# EUROPÄISCHE PATENTSCHRIFT

(11) **EP 2 630 674 B1**
(45) Veröffentlichungstag und Bekanntmachung des Hinweises auf die Patenterteilung: **13.08.2014**
(21) Anmeldenummer: 11767926.6
(22) Anmeldetag: 30.09.2011
(51) Int. Cl.: H01L 41/047, H01L 41/193, H01L 41/09, B60G 11/22, B60G 17/015, B60G 17/019, B60G 17/02, F16F 1/36, H02N 2/18

(54) **ELEKTROAKTIVER ELASTOMERWANDLER**
ELECTROACTIVE ELASTOMER CONVERTER
CONVERTISSEUR ÉLASTOMÈRE ÉLECTROACTIF

(30) Priorität: 22.10.2010 DE 102010049301
(43) Veröffentlichungstag der Anmeldung: 28.08.2013
(73) Patentinhaber: Fraunhofer-Gesellschaft zur Förderung der angewandten Forschung e.V., 80686 München (DE)
(72) Erfinder: KAAL, William, 64293 Darmstadt (DE); HEROLD, Sven, 64823 Groß-Umstadt (DE); MELZ, Tobias, 64285 Darmstadt (DE)
(74) Vertreter: Rösler, Uwe
(86) Internationale Anmeldenummer: PCT/EP2011/004930
(87) Internationale Veröffentlichungsnummer: WO 2012/052114

(56) Entgegenhaltungen:
- EP-A2- 0 614 705
- US-A1- 2007 114 885
- US-B1- 6 543 110
- NGUYEN ET AL: "Multi-stacked artificial muscle actuator based on synthetic elastomer", IROS 2007, 29. Oktober 2007 (2007-10-29), Seiten 771-776, XP031222635, ISBN: 978-1-4244-0911-2 in der Anmeldung erwähnt
- KOVACS G ET AL: "Stacked dielectric elastomer actuator for tensile force transmission", SENSORS AND ACTUATORS A, Bd. 155, Nr. 2, 1. Oktober 2009 (2009-10-01), Seiten 299-307, XP026708397, ISSN: 0924-4247, DOI: 10.1016/J.SNA.2009.08.027 [gefunden am 2009-09-08] in der Anmeldung erwähnt

## Beschreibung

### Technisches Gebiet

Die Erfindung bezieht sich auf einen elektroaktiven Elastomerwandler mit wenigstens einer elektroaktiven Elastomerschicht, die eine Ober- und Unterseite aufweist, sowie einem mit der Oberseite und einem mit der Unterseite zumindest bereichsweise flächig verbundenen, elektrisch leitfähigen Elektrodenkörper, wobei die Elektrodenkörper jeweils eine der Elastomerschicht zugewandte Elektrodenoberfläche besitzen, in der wenigstens eine Ausnehmung vorhanden ist, der ein Flächenbereich zuordenbar ist, in dem kein Flächenverbund zwischen der Elastomerschicht und dem Elektrodenkörper besteht.

Elektroaktive Elastomerwandler sehen wenigstens zwei voneinander beabstandete, zumeist schichtförmig ausgebildete Elektrodenkörper vor, zwischen denen eine Schicht aus dielektrischem Elastomer eingebracht ist, das über sehr große Dehnungseigenschaften, typischerweise von über 300% verfügt. Sehr häufig sind derartige Elastomerwandler in Form eines Mehrschichtstapelverbundes aufgebaut, der sich aus einer Vielzahl von Elastomer und Elektrodenschichten in jeweils abwechselnde Schichtabfolge zusammensetzt. In dem Stapelverbund befinden sich somit die aus dielektrischen Elastomermaterial bestehenden Elastomerschichten jeweils in einem Flächenverbund zwischen je zwei Elektrodenschichten und bilden einen kapazitiven Stapelverbund. Durch Anlegen einer geeignet gewählten elektrischen Spannung an die Elektrodenschichten wirken zwischen den Elektrodenschichten anziehende elektrostatische Kräfte, durch die die Elastomerschichten, insbesondere in Dickenrichtung komprimiert werden. Durch den stapelförmigen Wandleraufbau summieren sich die Dickenänderungen aller im Mehrschichtstapelverbund vorgesehenen Elastomerschichten zu einer aktorisch nutzbaren Stellwegänderung. Andererseits führt eine mechanische Deformation eines derartigen Mehrschichtstapelverbundes in Dickenrichtung der einzelnen Elastomerschichten zu einer Kapazitätsänderung des kapazitiven Stapelverbundes, die der elektrischen Energieerzeugung bzw. eines elektrischen Signalabgriffes dient.

Derartige auf dem so genannten Maxwell'schen. Spannungseffekt beruhende Elastomerwandler nutzen inkompressible Elastomere, die sich bei zwanghaften Formänderungen je nach Formgebung und Ausdehnungsmögtichkeiten mit gleich bleibendem Eigenvolumen deformieren. Um dem lateralen, d.h. in Flächenlängserstreckung orientierten Ausdehnungsvermögen von Elastomerschichten innerhalb eines Mehrschichtstapelverbundes Rechnung zu tragen, verfügen die eingesetzten Elektrodenschichten, die sich jeweils in einem Flächenhaftverbund mit den Elastomerschichten befinden, über laterale Ausdehnungseigenschaften.

### Stand der Technik

Der WO 2007 029275 A1 ist ein stapelförmig aufgebauter Aktor auf Basis eines elektroaktiven Polymers zu entnehmen, mit einem bandförmig ausgebildeten elektroaktiven Polymer, dessen beide Bandoberflächen jeweils mit einer flächenelastischen Flächenelektrode kontaktiert sind und einen bandförmigen Schichtverbund bilden, der mäanderförmig unter Ausbildung einer Vielzahl von stapelförmig übereinander liegenden Schichtverbundlagen gefaltet ist. Durch Anlegen einer elektrischen Spannung an die Flächehelektroden wirken auf die einzelnen elektroaktiven Polymerschichtlagen in Schichtdickenrichtung komprimierende Kräfte, wodurch sich der Aktor in Schichtdickenrichtung zu den einzelnen Schichtverbundlagen kontrolliert zusammenzuziehen vermag.

Der Einsatz von dehnfähigen Elektrodenschichten für den Aufbau von stapelförmig aufgebauten Elastomermultischichtwandler unter Verwendung synthetischer dielektrischer Elastomerschichten geht auch aus einem Beitrag von Chuc, Nguyen Huu; Park, Jong Kil; Thuy, Doan Vu; Kim, Hyon Seok; Koo, Ja Choon; Lee, Youngkwan et al. (2007): Multi-stacked Artificial Muscle Actuator Based on Synthetic Elastomer. In: Proceedings of the 2007 IEEE/RSJ International, S. 771-776 hervor. Der Artikel beschreibt insbesondere Elastomerwandlersysteme mit kreisringförmig oder rechteckförmig ausgebildeten Elastomer- sowie Elektrodenschichten.

Aus der US 2007/0114885 A1 ist ein elastomerer Vielschichtstapelaktor zu entnehmen, der als Elektrodenschichten dünne Metallschichten vorsieht, die materialbedingt zwar nicht dehnfähig sind, jedoch aufgrund einer welligen Struktur eine Verformung längs einer bevorzugten Raumachse ermöglichen.

Der US 6,543,110 B1 ist ein in Figur 2G illustrierter elastomerer Vielschichtstapelaktor zu entnehmen, der mehrere Elastomerschichten stapelförmig übereinander angeordnet vorsieht, die jeweils durch eine Adhesivschicht verbunden sind, in der zugleich auch eine räumlich unterbrochene Elektrodenschicht eingebracht ist, die zur Aktivierung der Elastomerschichten dienen. Somit grenzen die Elastomerschichten entweder an der Adhesivschicht oder an den Elektrodenflächen unmittelbar an.

Der Artikel von G. Kovac, L. Düring, S. Michel, G. Terrasi, "Stacked dielectric elastomer actuator for tensile force transmission, Sensor and Actuators A 155 (2009), S. 299 -307, enthält einen repräsentativen Überblick über den Stand der Technik bezüglich elastomerer Stapelwandler, die allesamt die Verwendung von elastischen Elektrodenschichten vorsehen.

Die bekannten elektroaktiven Elastomenivandlersysteme ermöglichen aufgrund der flächenelastischen Eigenschaften sowohl der Elastomer- als auch der Elektrodenschichten zwar verhältnismäßig große Stellwege bzw. Schichtdickenänderungen, jedoch ist das dynamische Ansprech- bzw. Betriebsverhalten derartiger Elastomerwandler aufgrund der flächenelastischen Eigenschaften sowohl in Flächenlängserstreckung als auch in Dickenrichtung zu den einzelnen Schichten eingeschränkt. Dies betrifft insbesondere den Frequenzbereich, mit dem es möglich ist, elektrische Energie bzw. elektrische Nutzsignale aus mechanischen Bewegungen, insbesondere aus Vibrationen mit Hilfe bekannter Elastomerwandler zu gewinnen.

### Darstellung der Erfindung

Der Erfindung liegt die Aufgabe zugrunde, einen elektroaktiven Elastomerwandler mit wenigstens einer elektroaktiven Elastomerschicht, die eine Ober- und Unterseite aufweist, sowie einem mit der Oberseite und einem mit der Unterseite zumindest bereichsweise flächig verbundenen, elektrisch leitfähigen Elektrodenkörper, wobei wenigstens ein Elektrodenkörper jeweils eine der Elastomerschicht zugewandte Elektrodenoberfläche besitzt, in der wenigstens eine Ausnehmung vorhanden ist, der ein Flächenbereich zuordenbar ist, in dem kein Flächenverbund zwischen der Elastomerschicht und dem Elektrodenkörper besteht, derart weiterzubilden, dass das dynamische Ansprechverhalten der vorzugsweise im Schichtverbund miteinander verbundenen Elastomerschichten und den jeweils dazwischen befindlichen Elektrodenkörper bzw. -schichten verbessert werden soll, es soll eine Umwandlung von mechanischer Schwingungsenergie in elektrische Energie auch bei höheren Schwingungsfrequenzen möglich sein. Umgekehrt gilt es gleichsam auch hochfrequente Stellwegänderungen in Form von Schichtdickenänderungen mittels entsprechend hochfrequenter elektrischer Spannungsanregung an den Elektrodenschichten zu realisieren.

Die Lösung der der Erfindung Zugrunde liegenden Aufgabe ist im Anspruch 1 angegeben. Den Erfindungsgedanken in vorteilhafter Weise weiterbildende Merkmale sind Gegenstand der Unteransprüche sowie der weiteren Beschreibung insbesondere auf Bezugnahme auf die illustrierten Ausführungsbeispiele zu entnehmen.

Ein lösungsgemäßer elektroaktiver Elastomerwandler nach den Merkmalen des Oberbegriffes des Anspruches 1 zeichnet sich dadurch aus, dass im Bereich der Ausnehmung ein kompressibles Medium vorgesehen ist, vorzugsweise ein Gas, bspw. Luft. Die Druckbedingungen, unter denen das kompressible Medium im Bereich der Ausnehmung mit der freien Oberfläche der Elastomerschicht in Wechselwirkung tritt, entsprechen vorzugsweise atmosphärischen Umgebungsdruckbedingungen, bspw. Standard-Normaldruckbedingungen, vorzugsweise 1013hPa. Je nach Bedarf und Einsatzzweck des Elastomerwandlers können die Druckbedingungen abweichend von den Umgebungsdruckbedingungen eingestellt werden, bspw. in Form eines Über- oder Unterdruckes bzw. in Form von Vakuumbedingungen. Hierzu bedarf es einer entsprechenden Kapselung eines die Ausnehmung umgebenden Volumens, die im Weiteren im Einzelnen erläutert wird.

Der Begriff "Elektrodenkörper" soll im Wesentlichen als schichtförmig ausgebildete Elektrode verstanden werden mit einer Schichtdicke, die nicht nur auf Größendimensionen von film- oder folienartig ausgebildeten Elektrodenschichten begrenzt sein soll, sondern auch makroskopische Schichtdickendimensionen umfassen soll, wie sie bspw. bei üblichen Blechlagen auftreten.

Im Unterschied zu bisherigen elastischen Elektrodenschichten, die einen möglichst vollständigen Flächenkontakt zu den jeweils anliegenden Elastomerschichten besitzer, sehen die lösungsgemäß ausgebildeten Elektrodenschichten Ausnehmungen in Form von Löcher oder Perforationen, die die Elektrodenschichten vollständig durchsetzen, oder zumindest konkave Mulden vor, die als lokale Vertiefungen an wenigstens einer Elektrodenschichtoberfläche eingebracht sind. Die lösungsgemäße Befüllung der Löcher bzw. Ausnehmungen innerhalb der Elektrodenschichten bzw. Elektrodenkörper, die ein- oder beidseitig jeweils von Elastomerschichten begrenzt sind, mit Luft oder einem anderen kompressiblen, Medium hat einen vorteilhaften Einfluss auf das Dehnungs- bzw. Stelfigkeitsverhalten des Elastomerwandlers. Alternativ ist es möglich im Bereich der Löcher bzw. muldenförmigen Ausnehmungen der Elektrodenschicht bzw. Elektrodenkörpers Vakuum bzw. Unterdruck vorzusehen, um auf diese Weise eine mechanische Vorspannung der Elastomerschicht zwischen den beiden Elektroden vorzusehen.

Zum Einschluss bestimmter Druckbedingungen innerhalb der Ausnehmungen eines Elektrodenkörpers ist eine beliebige Vielzahl stapelförmig übereinander angeordneter, elektroaktiver Elastomerschichten vorgesehen, zwischen denen jeweils ein Elektrodenkörper, vorzugsweise in Form einer film- oder folienartigen Elektrodenschicht, eingebracht ist, der wenigstens einseitig zu den jeweils angrenzenden Elastomerschichten eine Elektrodenoberfläche mit wenigstens einer Ausnehmung vorsieht, in der das kompressibles Medium, wie Luft eingeschlossen ist.

In einer bevorzugten Ausführungsform sehen die im stapelförmigen Schichtverbund vorgesehenen Elektrodenschichten Löcher bzw. Perforationen vor, wobei die Elektrodenschichten aus einem elektrisch gut leitenden metallischen Material bestehen und somit keine oder vernachlässigbar geringe flächenelastische Eigenschaften besitzen, d.h. die Elektrodenschichten sind zumindest in Flächenlängserstreckung dehnstarr. Der Begriff "dehnstarr" ist derart zu verstehen, dass die jeweils zwischen den elektroaktiven Elastomerschichten befindlichen Elektrodenschichten aus einem elektrisch sehr gut leitfähigen Material, vorzugsweise Metall, wie Kupfer, Aluminium, Stahl, Nickel etc., bestehen, dessen E-Modul um wenigstens vier Größenordnungen größer ist als das E-Modul der elektroaktiven Elästomerschichten, die vorzugsweise aus Silikonen oder PU-Elastomeren bestehen. Wird an einem derart ausgebildeten, stapelförmigem Schichtverbund mechanischer Druck in Dickenrichtung des Stapelverbundes ausgeübt, der entweder durch eine äußere mechanische Last oder durch ein elektrisches Feld hervorgerufen sein kann, so ermöglichen die in den Elektrodenschichten vorgesehenen Löcher bzw. Perforationen jeweils ein lokales Eindringen des ansonsten inkompressiblen Elastomers, wodurch eine makroskopische Kompressibilität der gesamten Schichtstruktur in Dickenrichtung gewährleistet ist. Aufgrund der Flächensteifigkeit der einzelnen Elektrodenschichten wird das Ausdehnungsbestreben der zwischen den Elektrodenschichten eingebrachten Elastomerschichten in Flächenlängserstreckung weitgehend unterdrückt.

Alternativ zur Verwendung von gelochten oder perforierten Elektrodenschichten ist der Einsatz schichtförmig ausgebildeter Elektrodenkörper denkbar, die zumindest an der der Elastomerschicht zugewandten Elektrodenoberfläche eine konkave Ausnehmung bzw. konkave Form in Art einer in der Elektrodenoberfläche eingebrachten Mulde vorsieht. Die Mulde dient gleichsam wie die vorstehend bezeichneten Löcher oder Perforationen als Ausdehnungsraum, in den sich das inkompressible Elastomer der Elastomerschicht bei mechanischem Druck in Dickenrichtung lokal auszubreiten vermag. Die konkaven Mulden innerhalb der Elektrodenkörper schließen mit der Oberfläche der Elastomerschicht jeweils gasdicht ab und umfassen somit ein Volumen innerhalb dem das kompressible Medium unter bestimmten Druckbedingungen eingeschlossen ist.

Typische Lochdimensionen bzw. maximale Durchmesser der Ausnehmungen innerhalb der vorstehend beschriebenen schichtförmig ausgebildeten Elektrodenkörper liegen vorzugsweise in der gleichen Größenordnung wie die Schichtdicke der Elektrodenschicht bzw. des Elektrodenkörpers bzw. der Elastomerschicht.

Spezielle Anforderungen an die geometrische Ausgestaltung der Löcher bzw. der muldenförmigen Ausnehmung bestehen grundsätzlich nicht, gleichwohl es vorteilhaft ist, insbesondere an den Übergangsbereichen von Loch und Elektrodenschichtoberfläche bzw. an den Randbereichen der muldenförmigen Ausnehmungen bevorzugt runde Konturen vorzusehen, um Materialrisse innerhalb der Elastomerschicht zu vermeiden. Insbesondere das Vorsehen von runden Übergängen an den Loch- oder Muldenrändern trägt zu einer kontinuierlichen Flächenkontaktierung zwischen den Elastomerschichten und den Elektrodenschichten im Bereich ihrer Löcher bzw. Ausnehmungen bei, wodurch messbar große Kapazitätsänderungen bei kleinen Stellwegen, d.h. bei geringen Dickenänderungen die Folge sind, so dass eine Energiewandlung bei hohen Frequenzen ermöglicht wird. So ergibt sich insbesondere mit einer zunehmenden elektrischen Spannung bzw. einem zunehmenden, von außen auf eine Mehrfachstapelanordnung einwirkenden mechanischen Druck eine Vergrößerung der anliegenden Flächenbereiche der einzelnen Elastomerschichten an den Innenseiten der Löcher bzw. Ausnehmungen, wodurch die elektrische Kapazität sowie auch die mechanische Steifigkeit des Stapelverbundes zunimmt. Je nach geometrischer Ausprägung der Löcher bzw. Ausnehmungen lassen sich auf diese Weise progressive Steifigkeits- bzw. Kapazitätskennlinien entwerfen, so dass ein derart lösungsgemäß ausgebildeter elektroaktiver Elastomerwandler in bevorzugter Weise als adaptiver Tilger, d.h. Schwingungsdämpfungselement, eingesetzt werden kann, dessen resonantes Schwingungsverhalten durch quasistatische Ansteuerung des Steifigkeitsverhaltens gezielt verstellt bzw. einstellbar ist.

Auch ist eine weitere Verwendung des lösungsgemäß ausgebildeten elektroaktiven Elastomerwandlers als Flächenlautsprecher oder als aktiv regelbare Wandimpedanz denkbar, bei der zwischen wenigstens zwei, wenigstens eine Elastomerschicht beidseitig begrenzenden Elektrodenkörpern eine elektrische Steuerspannung angelegt wird, durch die dem schichtförmigen Elastomerwandler ein bestimmtes Schwingungsverhalten eingeprägt wird, das zur Erzeugung von Audiosignalen oder zu Schalldämpfungszwecken in Räumen oder an Gegenständen dient. In vorteilhafterweise sind hierzu längs einer Ober- und/oder Unterseite einer Elastomerschicht wenigstens zwei Elektrodenkörper räumlich getrennt voneinander angebracht, an die jeweils unterschiedliche elektrische Steuerspannungen anlegbar sind, um auf diese Weise das Schwingungsverhalten des Elastomerwandlers längs seiner gesamten Flächenerstreckung individuell zu beeinflussen. Weitere Einzelheiten hierzu folgen in Verbindung mit der Erläuterung illustrierter Ausführungsformen.

### Kurze Beschreibung der Erfindung

Die Erfindung wird nachstehend ohne Beschränkung des allgemeinen Erfindungsgedankens anhand von Ausführungsbeispielen unter Bezugnahme auf die Zeichnungen exemplarisch beschrieben. Es zeigen:
- Fig. 1a,b: Draufsicht und Längsschnitt durch eine lösungsgemäß ausgebildete Elektrodenschicht,
- Fig. 2a,b: Querschnittsdarstellungen durch eine Schichtanordnung bestehend aus zwei perforierten Elektrodenschichten mit einer zwischenliegenden Elastomerschicht ohne Druckeinwirkung a) sowie mit Druckeinwirkung b) in Schichtdickenrichtung,
- Fig. 3a,b,c,d: Längsschnittdarstellungen durch einen lösungsgemäß ausgebildeten elektroaktiven Elastamerwandler mit gelochten Elektrodenschichten mit abgerundeten Lochkanten in unterschiedlichen Druckzuständen,
- Fig. 4a,b,c: lösungsgemäß ausgebildeter elektroaktiver Elastomerwandler mit schichtförmigen Elektrodenkörpern, in denen konkave muldenförmig ausgebildete Ausnehmungen eingebracht sind,
- Fig. 5: elektroaktiver Elastomerwandler zwischen zwei festen Gegenlagern,
- Fig. 6 a, b: Herstellungsschritte für einen kostengünstigen, stapelförmig aufgebauten Elastomerwandler,
- Fig. 7: Elastomenwandler mit in Stapelrichtung versetzt zueinander ausgerichteten, mit Ausnehmungen versehenen Elektrodenschichten, sowie
- Fig. 8: Ausführurigsbeispiel für einen elektroaktiven Elastomerwandler zu Zwecken eines haptisch bedienbaren Tastenfeldes.

### Wege zur Ausführung der Erfindung, gewerbliche Verwendbarkeit

Der lösungsgemäß ausgebildete elektroaktive Elastomerwandler sieht in einer einfachsten Ausführungsform lediglich eine Elastomerschicht vor, die zwischen zwei mit Löchern oder Ausnehmungen versehene Elektrodenschichten eingebracht ist.

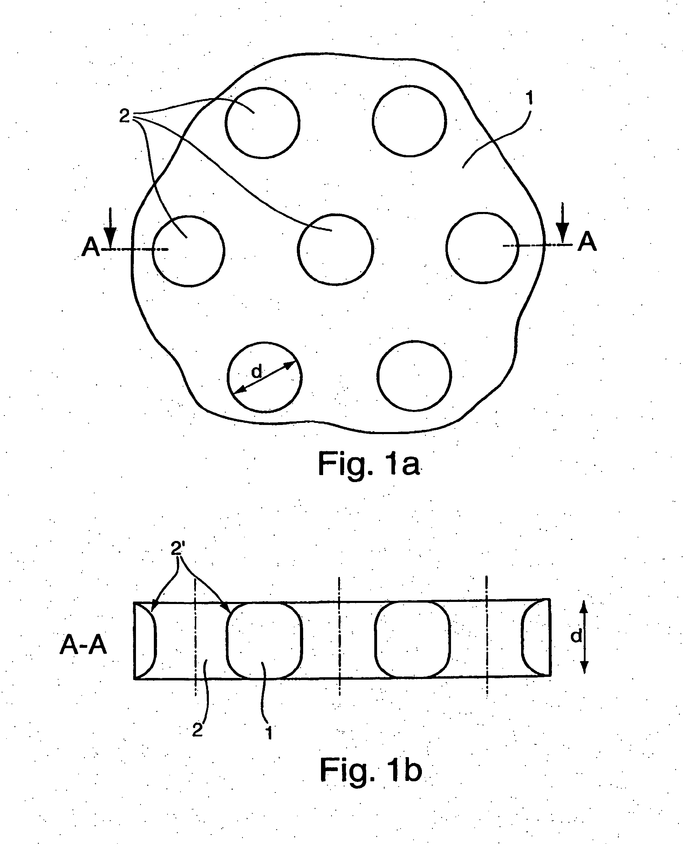

In Figur 1a ist die Draufsicht auf einen Bereich einer mit Löchern 2 durchsetzte Elektrodenschicht 1 dargestellt, die vorzugsweise in Form eines Metallbleches oder einer Metallfolie ausgeführt sein kann. Die in die Elektrodenschicht 1 eingebrachten Löcher 2 sehen an ihren Lochrändern 2' runde Konturen vor, wie dies aus der Längsschnittdarstellung gemäß Fig. 1b zu entnehmen ist. Figur 1b stellt den Längsschnitt AA durch die in Fig. 1a dargestellte Schnittebene AA dar.

Die mit Löchern 2 durchsetzte Elektrodenschicht 1 weist typischerweise eine Schichtdicke von wenigstens einigen µm auf. Die Durchmesser d der in die Elektrodenschicht 1 eingebrachten Löcher 2 entsprechen in etwa jener der Elektrodenschicht oder der Elastomerschicht.

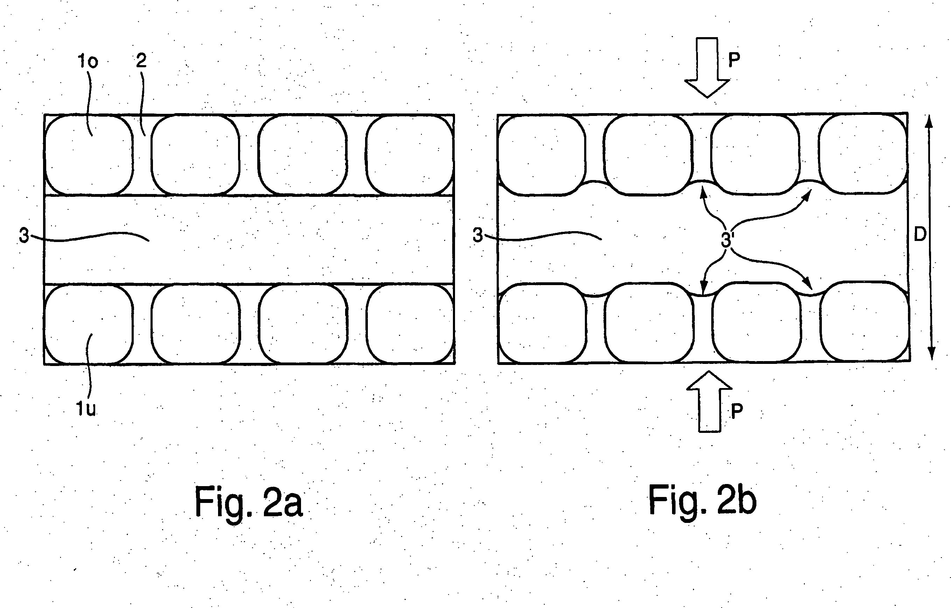

In Figur 2a ist ein einfachstes Ausführungsbeispiel zur Realisierung eines lösungsgemäß ausgebildeten elektroaktiven Elastomerwandlers dargestellt. Zwischen zwei der vorstehend beschriebenen, mit Löchern 2 versehenen Elektrodenschichten 1u, 1o ist eine dielektrische Elastomerschicht 3 eingebracht, die mit beiden Elektrodenschichten innerhalb der jeweiligen Kontaktbereiche, d.h. die Elektrodenoberflächenbereiche, die die Löcher 2 umgeben, einen innigen Flächenhaftverbund eingehen. Die flächenhafte Fügung zwischen den einzelnen Elektrodenschichten 1u, 1o und der dazwischen befindlichen Elastomerschicht 3 gewährleistet, dass die miteinander verbundenen Schichten in Schichtlängserstreckung "unverschieblich" verbunden sind. Ein entsprechender Haftverbund zwischen den innerhalb der Lochausnehmungen 1 befindlichen freien Oberflächenbereichen der Elastomerschicht 3 und den Elektrodenschichten 1 u, 1o besteht nicht. Der in Figur 2a im Querschnitt illustrierte Haftverbund zwischen den beiden Elektrodenschichten 1u, 1o und der dazwischen befindlichen Elastomerschicht 3 stellt einen Zustand dar, in dem keinerlei äußere Kräfte auf den Haftverbund einwirken. Demgegenüber sei in der Querschnittsdarstellung gemäß Figur 2b angenommen, dass ein mechanischer Druck p in Dickenrichtung zur Elastomerschicht 3 einwirkt. Der mechanische Druck kann entweder durch eine äußere mechanische Last auf den Schichtverbund hervorgerufen sein oder aber durch ein elektrisches Feld verursacht sein, das durch eine entsprechend elektrische Vorspannung zwischen beiden Elektrodenschichten 1 u, 1 o hervorgerufen wird. Aufgrund der Inkompressibilität des dielektrischen Elastomers 3 sowie der Unterbindung einer in Flächenlängserstreckung orientierten Deformation der Elastomerschicht 3 durch den vorstehend skizzierten unverschieblichen Haftverbund zur oberen und unteren Elektrodenschicht 1o, 1 u vermag sich das inkompressible Elastomer lediglich lokal in die innerhalb der Elektrodenschichten 1u, 1o vorgesehenen Löcher auszudehnen, wie dies durch die lokalen Deformationen 3' der Elastomerschicht 3 anhand der Figur 2b entnommen werden kann. Durch den Vorgang des lokalen Entweichens von oberflächennahen Elastomerantellen in den Bereich der Löcher 2 innerhalb der einzelnen Elektrodenschichten 1o, 1u wird die Dicke D des in Figur 2b dargestellten Gesamtschichtverbundes kompressionsbedingt reduziert ohne nennenswerte Ausdehnung der Elastomerschicht in Flächenlängserstreckung.

Der in Figur 2a und b illustrierte Schichtverbund von jeweils einer Elastomerschicht 3 mit zwei gelocht oder perforiert ausgeführten Elektrodenschichten 1u, 1o kann in stapeiförmiger Ausbildung mit einer Vielzahl weiterer Elastomer- und Elektrodenschichten kombiniert werden, um auf diese Weise einen vielschichtigen Stapelverbund zu erhalten, mit jeweils abwechselnder Schichtabfolge jeweils von Elastomerschicht und perforierter Elektrodenschicht. In einer derartigen Mehrschichtabfolge führt durch Summation der Dickenänderungen aller Elastomerschichten bei einer entsprechenden mechanischen Druckwirkung gemäß Figur 2b zu einer skalierbar makroskopischen Dickenänderung des gesamten Stapelverbundes, der im Falle einer Aktoranwendung als Aktorstellweg genutzt werden kann.

Je nach Anwendungs- und Einsatzzweck lässt sich der elektroaktive Elastomerwandler als Aktor oder Sensor betreiben. Im Falle eines Aktorbetriebes wird elektrische Energie gezielt in Bewegungsenergie umgesetzt, die sich letztlich in Form einer dynamischen Stellwegänderung auswirkt. In diesem Falle gilt es zwischen zwei Elektrodenschichten eine elektrische Spannung anzulegen, die zwischen beiden Elektrodenschichten zu einem elektrostatischen Feld führt, wodurch beide Elektrodenschichten aufgrund elektrostatischer Anziehungskräfte angezogen werden. Hierdurch wird die dazwischen befindliche Elastomerschicht in der vorstehend beschriebenen Weise komprimiert, wodurch sich der Stapelschichtverbund verglichen zur Ausgangsstapelhöhe bzw. -dicke reduziert. Aufgrund der materialinhärenten Flächensteifigkeit der gelochten bzw. perforierten Elektrodenschichten und einer damit verbundenen, weitgehend ausschließlich nur in Dickenrichtung der Elastomerschichten erfolgenden Deformierbarkeit der zwischen beiden Elektrodenschichten eingeschlossenen Elastomerschicht, können dynamische Stellweg- bzw. Dickenänderungen realisiert werden, die mit den bisher üblichen vergleichbaren Stapelaktoren, bei denen flächenelastische Elektrodenschichten eingesetzt sind, nicht erreichbar sind. Gleichwohl geringere Dickenänderungen und damit verbunden geringere Stellwegänderungen möglich sind, vermag der neuartige Elastomerwandler ungleich höherfrequente elektrische Spannungen in mechanische Dickenschwingungen umzusetzen als es bisher der Fall ist. Dies liegt vor allem darin begründet, dass die Elastomerschichten lediglich in den Bereichen der Ausnehmungen bzw. Löcher Deformationsarbeit verrichten und nicht wie bisher, längs ihres gesamten lateralen Umfangsbereiches.

Gilt es hingegen den lösungsgemäß ausgebildeten Elastomerwandler als Sensor zu betreiben, d.h. eine auf den Schichtverbund einwirkende mechanische Schwingungsenergie soll in elektrische Energie überführt werden, so trägt die dynamische Deformation der Elastomerschicht in den Bereichen der Löcher zu einer dynamischen Kontaktflächenveränderung zwischen der Elastomerschicht und den Elektrodenschichten bei. Da die Elektrodenschichten mit einer zwischenliegenden Elastomerschicht als Kondensatoranordnung angesehen werden kann, ändert sich mit unterschiedlichem Flächenkontakten zwischen der Elastomerschicht und den Elektrodenschichten die Kapazität der Kondensatoranordnung, wodurch letztlich eine messbare und an den Elektrodenschichten abgreifbare Spannungsänderung die Folge ist. Aufgrund der nahezu ausschließlichen Kompressibilität der Elastomerschicht in Dickenrichtung führen selbst kleine Dickenänderungen in der Elastomerschicht zu großen Kapazitätsänderungen, die messtechnisch in Form elektrischer Signale abgegriffen werden können. Ein besonders bedeutender Vorteil des lösungsgemäßen Elastomerwandlers stellt die Fähigkeit dar, hochfrequente mechanische Schwingungen mit kleinen Amplituden in elektrisch mess- bzw. erfassbare Signale umzuwandeln.

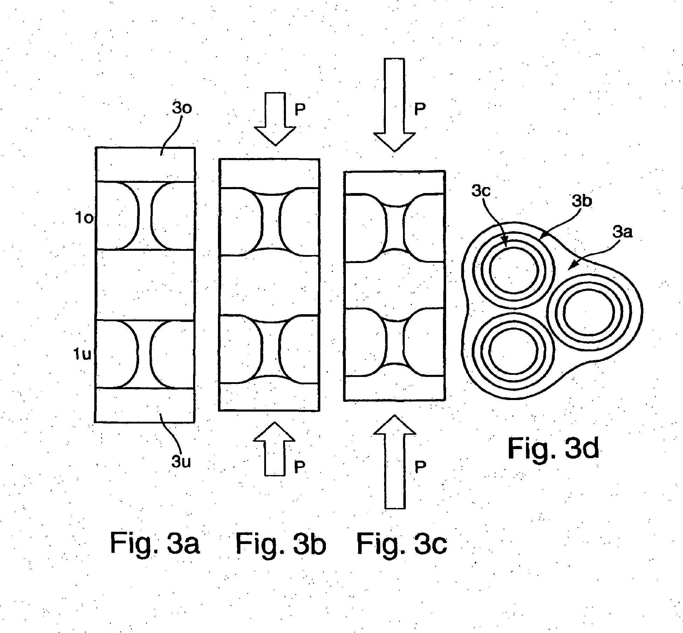

In Figur 3a ist ein Teilquerschnitt durch ein Schichtaufbau illustriert, der vergleichbar mit der in Figur 2a dargestellten Schichtabfolge ist, jedoch durch zwei weitere Elastomerschichten, d.h. eine obere und eine untere Elastomerschicht 3o, 3u in der dargestellten Weise ergänzt ist. Somit werden die perforierten Elektrodenschichten 1u, 1o jeweils beidseitig von Elastomerschichten 3u, 3, 3o begrenzt und damit die Löcher 2 innerhalb der Elektrodenschichten 1 u, 1o gasdicht begrenzt. Somit bietet sich die Möglichkeit innerhalb der Löcher 2 Luft oder ein anderes kompressibles Medium einzuschließen, denkbar wäre beispielsweise ein Medium mit einer hohen Dielektrizitätszahl, um die Ausprägung des elektrischen Feldes zwischen und innerhalb der einzelnen Elektrodenschichten zu verbessern. Alternativ hierzu könnte erwogen werden, innerhalb der durch die Elastomerschichten 3u, 3, 3o eingeschlossenen Zwischenräume 2 Vakuum oder Unterdruck vorzusehen, beispielsweise indem der Vorgang des Fügens der einzelnen Schichten unter Vakuumbedingungen durchgeführt wird, um auf diese Weise eine mechanische Vorspannung zwischen den einzelnen Elastomerschichten zu erzielen. Eine derartige mechanische Vorspannung könnte bei einem Aktorbetrieb vorteilhaft eingesetzt werden, da auf diese Weise auch Zugkräfte aufgebracht werden können, ohne dabei den Flächenverbund voneinander zu trennen.

Geht man von der Schichtdarstellungen in Figur 3a aus, bei der kein mechanischer Druck auf die Elastomerschichten einwirkt, so führt ein auf den Schichtverbund einwirkender mechanischer Druck p mit zunehmender Stärke, siehe Bildsequenzen 3b, 3c, zu einer zunehmenden Verformung der einzelnen Elastomerschichfen jeweils innerhalb der Lochbereiche, wodurch der Flächenkontakt zwischen den Elastomerschichten 3u, 3, 3o mit zunehmender Druckstärke p, P ebenfalls zunimmt. Figur 3d illustriert die unterschiedlichen Berührflächen, die mit den Bilddarstellungen gemäß Figur 3a, 3b, 3c korrespondieren. Mit zunehmendem mechanischem Druck p auf den Schichtverbund, bedingt durch eine zunehmende elektrische Spannung zwischen den einzelnen Elektrodenschichten bzw. eine zunehmende äußere Druckeinwirkung, ergibt sich eine zunehmende Vergrößerung der anliegenden Flächen und damit verbunden eine zunehmende elektrische Kapazität bzw. mechanische Steifigkeit. Je nach geometrischer Ausprägung der Löcher 2 lassen sich auf dieser Weise progressive Steifigkeits-/ bzw. Kapazitätskennlinien für den Schichtverbund entwerfen. Im Fall gemäß Figur 3c ist der größte Flächenkontakt zwischen Elastomerschichten und Elektrodenschichten vorhanden, d.h. dieser Fall stellt die größte Kapazität sowie auch Steifigkeit dar. Demgegenüber besitzt der in Figur 3a illustrierte Schichtverbund die geringste Steifigkeit bzw. den geringsten Flächenkontakt und damit verbunden die geringste Kapazität.

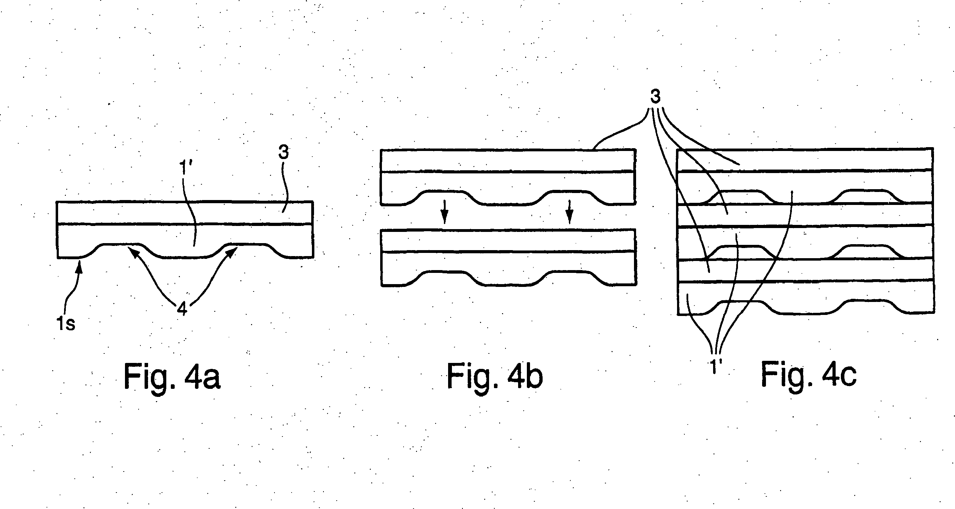

Alternativ zur Ausbildung der Elektrodenschichten bzw. -körper mit durchgehenden Löchern bzw. Perforationen ist es ebenso möglich, die Elektrodenschichten zumindest einseitig mit muldenartigen Ausnehmungen zu versehen. In Figur 4a ist ein derartiger Elektrodenkörper 1' in einer Querschnittsdarstellung gezeigt, der einseitig mit einer Elastomerschicht 3 verbunden ist. Der Elektrodenkörper 1' weist eine strukturierte Oberfläche 1s auf, in der muldenartige, konkave Ausnehmungen 4 eingebracht sind. In der in Figur 4a dargestellten Ausführungsform weist der Elektrodenkörper 1' eine der strukturierten Oberseite 1 s gegenüberliegende glatte Oberseite auf, die mit der Elastomerschicht 3 verbunden ist. Die Ausnehmungen 4 können durch Prägen oder Walzen in die Oberfläche des Elektrodenkörpers 1' eingebracht werden. Durch die glatte Ausbildung der der strukturierten Oberfläche 1s gegenüberliegenden Oberfläche des Elektrodenkörpers 1' ist es möglich, die Elastomerschicht 3 durch Rakeln oder Sprühen aufzubringen. Auf diese Weise können sehr dünne Schichtdicken realisiert werden. Der in Figur 4a dargestellte Schichtverbund stellt eine Art Halbzeug dar, das durch Übereinanderstapeln mit einem weiteren Halbzeug oder einer Vielzahl weiterer Halbzeuge zu einer Stapelanordnung zusammengefügt werden kann, wie dies aus den Querschnittsdarstellungen gemäß der Figuren 4b und c zu entnehmen ist. Figur 4c stellt einen in beliebiger Fortsetzung erweiterbaren Elsatomerwandler mit jeweils drei übereinander gefügten Halbzeugen gemäß Figur 4a dar. Auch indiesem Fall vermögen die Elastomerschichten 3 jeweils in die konkaven Ausnehmungen der einzelnen Elektrodenkörper 1' bei mechanischem Zwang auszuweichen.

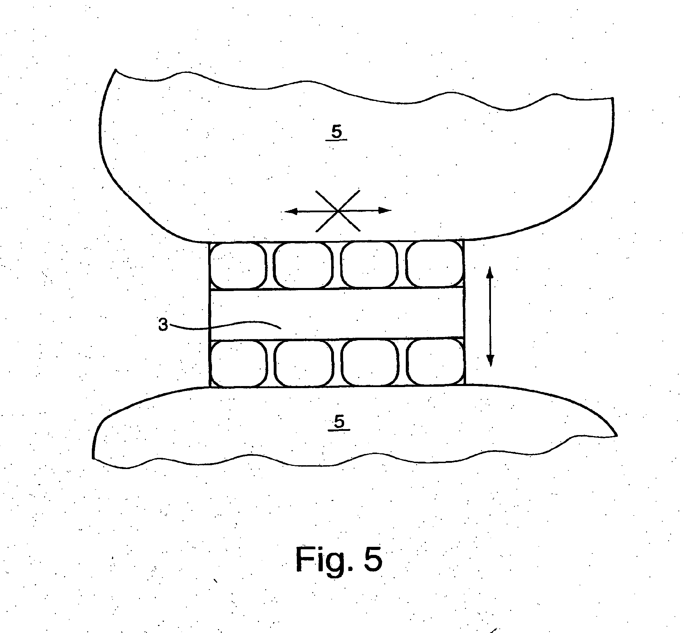

Ein lösungsgemäß ausgebildeter Elastomerwandler ermöglicht aufgrund der jeweils flächenstarr bzw. dehnstarr ausgebildeten Elektrodenkörper einen direkten Anschluss an weitestgehend beliebige Peripheriekonturen 5, wie dies aus Figur 5 zu entnehmen ist. So können Stapelwandler mit wenigen Schichten, wie im Falle der Figur 5 sogar mit nur einer einzigen Elastomerschicht 3 sinnvoll genutzt werden, zumal keine parasitären Randeffekte bei der Anbringung an periphere Halte- oder Stützkonturen auftreten. Damit ist ein entscheidender Vorteil gegenüber herkömmlichen, dehnweichen Elektroden gewährleistet.

Der lösungsgemäße Elastomerwandler ermöglicht eine technologisch einfache, robuste und kostengünstige Bauweise aufgrund des Einsatzes von flächenstarren Elektrodenschichten, vorzugsweise in Form von Metallelektroden. Aufgrund der dehnstarren jeweils außen liegenden Rundelektroden, vgl. Fig. 5, können das Wandlersystem irritierende Einspannungseffekte vollständig vermieden werden.

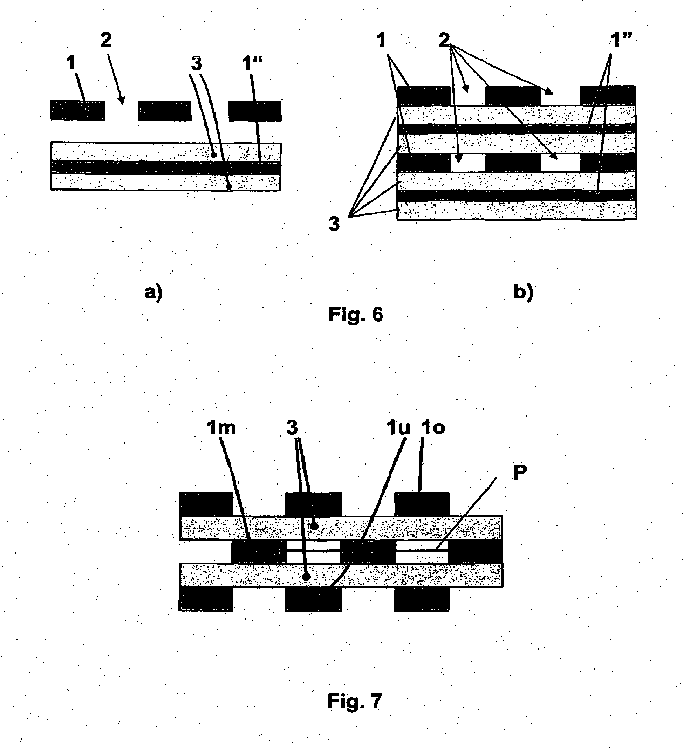

In den Figuren 6a und 6b ist ein weiteres Ausführungsbeispiel zur Realisierung eines elektroaktiven Elastomerwandlers illustriert, der sich durch eine besonders kostengünstige Herstellungsweise auszeichnet. Ausgehend von einer durchgängig ausgebildeten Elektrodenschicht, d.h. ohne jegliche Ausnehmungen in Form von Löcher oder Mulden, wie sie beispielsweise als herkömmliche Metallfolie vorliegt, werden auf beiden Oberflächen der Elektrodenschicht jeweils eine dünne Elastomerschicht 3 aufgebracht. Auf diesen Dreischichtenverbund wird zumindest auf der Oberfläche einer Elastomerschicht 3 eine mit Ausnehmungen, hier in Form von Löchern 2, versehene Elektrodenschicht 1 aufgebracht. Ein derartiger, aus vier Schichten bestehender Elastomerwandlerschicht-Stapel bildet eine Art Stapel-Grundmodul, mit dem durch eine beliebig wiederholte, stapelförmige Übereinanderanordnung des Grundmoduls die Realisierung eines Elastomerwandler möglich ist, der in Fig. 6b mit jeweils nur zwei übereinander angeordneten Stapel-Grundmodulen illustriert ist. Der auf diese Weise herstellbare Elastomerwandler sieht jeweils in abwechselnder Stapelabfolge eine ungelochte 1" sowie jeweils gelochte Elektrodenschicht 1 vor, die jeweils durch eine Elastomerschicht 1 getrennt sind. In dem in Fig. 6b illustrierten Ausführungsbeispiel sind die jeweils gelochten Elektrodenschichten 1 in Stapelrichtung derart zueinander ausgerichtet, so dass ihre Ausnehmungen, hier in Form von Löchern 2, in Stapelrichtung jeweils vollständig überlappend zueinander angeordnet sind. Eine derartig vollständig überlappende Anordnung der Ausnehmungen 2 in den jeweiligen Elektrodenschichten 1 ist jedoch nicht zwingend erforderlich. Auch ist es möglich, durch lateralen Versatz der Ausnehmungen bzw. Löcher 2 innerhalb der einzelnen gelochten Elektrodenschichten 1 untereinander Einfluss auf das makroskopische Ausdehnungsverhalten des gesamten Elastomerwandlers zu nehmen. So beeinflusst die laterale Position der gelochten Elektrodenschichten 1 relativ zueinander sowohl die mechanischen als auch die elektrischen und elektromechanischen Eigenschaften des gesamten Wandlerelementes.

In Fig. 7 ist ein Schichtaufbau eines lösungsgemäß ausgebildeten Elastomerwandlers gezeigt, bei dem die gelochten Elektrodenschichten 1o, 1 m, 1 u jeweils durch eine Elastomerschicht 3 voneinander beabstandet sind. Die mittlere, gelochte Elektrodenschicht 1 m ist bezüglich der Lage ihrer Löcher 2 lateral zur Position der Löcher innerhalb der oberen Elektrodenschicht 1 o und unteren Elektrodenschicht 1o versetzt angeordnet, so dass keine gegenseitige Überlappung der Löcher in Stapelrichtung vorgesehen ist. Die durch den Horizontalpfeil P angedeutete laterale Verschiebung der mittleren Elektrodenschicht 1 m relativ zur oberen und unteren Elektrodenschicht 1o, 1u soll verdeutlichen, dass der laterale Versatz Variabel, je nach gewünschten makroskopischen Eigenschaften des Elastomerwandlers hinsichtlich mechanischer, elektrischer und elektromechanischer, Eigenschaften vorgenommen werden kann.

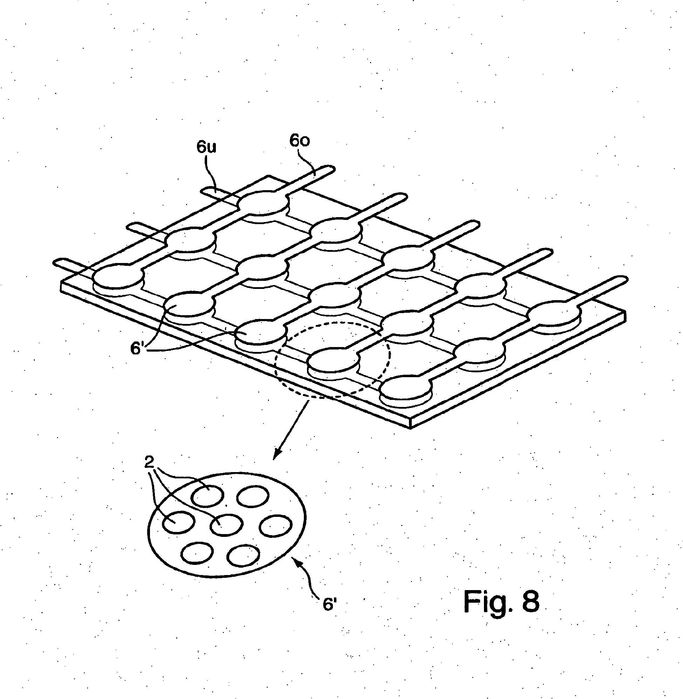

In Fig. 8 ist ein Ausführungsbeispiel für einen elektroaktiven Elastomerwandler illustriert, der die Form und Funktion eines haptisch bedienbaren Tastenfeldes besitzt. Der Elastomerwandler sieht eine Elastomerschicht 3 vor, auf deren Unter-und Oberseite mehrere, jeweils getrennt voneinander angeordnete, streifenförmig ausgebildete Elektrodenschichten 6o, 6u angeordnet sind, die jeweils mehrere kreisförmig ausgebildete Elektrodenfelder 6' vorsehen. Die kreisrund ausgebildeten Elektrodenfelder 6', die längs der jeweils streifenförmig ausgebildeten Elektrodenschichten 6o, 6u sowohl an der Ober- als auch Unterseite der Elastomerschicht 3 angebracht sind, sind jeweils paarweise vollständig überlappend angeordnet und bilden jeweils ein Wandlermodul. Jede einzelne, kreisförmig ausgebildete Elektrodenfläche 6' weist Ausnehmungen in Form von Perforierungen bzw. Löcher 2 auf, wie dies aus der Detaildarstellung gemäß Fig. 8 zu entnehmen ist. Größe, Anzahl, und Anordnung der Ausnehmungen 2 auf jedem kreisrund ausgebildeten Elektrodenfeld 6' können gleich oder jeweils individuell für jedes einzelne Elektrodenfeld 6' gewählt werden.

Mit Hilfe einer in Figur 8 dargestellten Anordnung kann, wie bereits erwähnt ein haptisch bedienbares Tastenfeld realisiert werden, indem durch ortsselektives Erfassen von Änderungen der kapazitiven Verhältnisse jeweils im Bereich eines Wandlermoduls eine bestimmte Funktion verknüpfbar ist, die durch Betätigen des jeweiligen Wandlermoduls ausgelöst werden kann.

Die einzelnen jeweils aus zwei, durch eine gemeinsame Elastomerschicht 3 getrennt voneinander angeordneten Elektrodenflächen 6' bestehenden Wandlermodule nutzen eine gemeinsame Elastomerschicht 3 und sind somit eng miteinander verbunden.

Ferner kann die Anordnung auch als Aktor-/Sensorfeld eingesetzt werden, je nachdem, wie die einzelnen Wandlermodule über die einzelnen Elektrodenschichten 6o, 6u mit gleicher oder unterschiedlicher Steuerspannung versorgt werden oder mit entsprechenden Detektoreinheiten verbunden sind.

Mit dem in Figur 8 vorgeschlagenen Anordnungsprinzip lassen sich unter Verwendung von nur einer oder mehreren übereinander angeordneten Elastomerschichten 3, zwischen denen jeweils die in Figur 8 ersichtlichen Elektrodenschichten 6o, 6u eingebracht sind, großflächige, dünne Aktoren aufbauen, die als Flächenlautsprecher oder als aktiv steuerbare bzw. regelbare

Wandimpedanzen eingesetzt werden können. Derartige flächige Aktoren lassen sich platzsparend in große, flächige Strukturen integrieren

In besonderer Weise lässt sich der lösungsgemäß ausgebildete Elastomerwandler auch als Schwingungsdämpfungssystem in technische Systeme und Strukturen einsetzen, so beispielsweise insbesondere in der Automobiltechnik, Maschinen- und Anlagenbau. Auch und insbesondere eignet sich der lösungsgemäß ausgebildete Elastomerwandler zur Energiegewinnung aus Vibrationen, so genanntes Energy Harvesting

### Bezugszeichenüste

- 1: Elektrodenschicht
- 1': Elektrodenkörper
- 1u: untere Elektrodenschicht
- 1o: obere Elektrodenschicht
- 1s: Strukturierte Oberfläche
- 2: Loch
- 2': Lochrand bzw. Lochrandbereich
- 3: Elastomerschicht
- 4: Nutförmige bzw. konkave Ausnehmung
- 5: Peripheriekontur
- 6': Elektrodenfeld
- 6o, 6u: Elektrodenschicht

## Patentansprüche

1. Elektroaktiver Elastomerwandler mit wenigstens einer elektroaktiven Elastomerschicht (3), die eine Ober- und Unterseite aufweist, sowie einem mit der Oberseite und einem mit der Unterseite zumindest bereichsweise flächig verbundenen, elektrisch leitfähigen Elektrodenkörper (1'), wobei wenigstens ein Elektrodenkörper (1') jeweils eine der Elastomerschicht (3) zugewandte Elektrodenoberfläche besitzt, in der wenigstens eine Ausnehmung (2) vorhanden ist, der ein Flächenbereich zuordenbar ist, in dem kein Flächenverbund zwischen der Elastomerschicht (3) und dem Elektrodenkörper (1') besteht,
**dadurch gekennzeichnet, dass** die wenigstens eine Ausnehmung (2) von der Elastomerschicht (3) einseitig begrenzt ist und im Bereich der Ausnehmung (2) ein kompressibles Medium vorgesehen ist.

2. Elektroaktiver Elastomerwandler nach Anspruch 1,
**dadurch gekennzeichnet, dass** der Elektrodenkörper (1') dehnstarr ist.

3. Elektroaktiver Elastomerwandler nach Anspruch 1 oder 2,
**dadurch gekennzeichnet, dass** der Elektrodenkörper (1') ein E-Modul besitzt, das um wenigstens vier Größenordnungen größer ist als ein der Elastomerschicht (3) zuordenbarer E-Modul ist.

4. Elektroaktiver Elastomerwandler nach einem der Ansprüche 1 bis 3,
**dadurch gekennzeichnet, dass** der Elektrodenkörper (1') als eine elektrisch leitende Schicht (1) ausgebildet ist, und
dass die wenigstens eine Ausnehmung in Form eines Loches (2) oder einer Perforation, die die elektrisch leitende Schicht (1) vollständig durchsetzt, ausgebildet ist.

5. Elektroaktiver Elastomerwandler nach einem der Ansprüche 1 bis 3,
**dadurch gekennzeichnet, dass** die wenigstens eine Ausnehmung in der der Elastomerschicht (3) zugewandten Elektrodenoberfläche des Elektrodenkörpers eine konkave Form (4) besitzt, d.h. in Art einer in der Elektrodenoberfläche eingebrachten Mulde ausgebildet ist.

6. Elektroaktiver Elastomerwandler nach einem der Ansprüche 1 bis 5,
**dadurch gekennzeichnet, dass** der Elektrodenkörper (1') als Metallblech oder Metallfolie ausgebildet ist.

7. Elektroaktiver Elastomerwandler nach Anspruch 4,
**dadurch gekennzeichnet, dass** das wenigstens eine Loch (2) oder die wenigstens eine Perforation einen Durchmesser besitzt, der einer der Elastomerschicht (3) oder einer dem Elektrodenkörper (1') zuordenbaren Schichtdicke entspricht.

8. Elektroaktiver Elastomerwandler nach Anspruch 5,
**dadurch gekennzeichnet, dass** die wenigstens eine Mulde (4) eine größte Durchmesserdimension besitzt, die einer der Elastomerschicht (3) oder einer dem Elektrodenkörper (1') zuordenbaren Schichtdicke entspricht.

9. Elektroaktiver Elastomerwandler nach Anspruch 5 oder 8,
**dadurch gekennzeichnet, dass** die wenigstens eine Mulde mit der Elastomerschicht ein Volumen gasdicht umschließt, in dem das kompressible Medium eingeschlossen ist.

10. Elektroaktiver Elastomerwandler nach einem der Ansprüche 1 bis 9,
**dadurch gekennzeichnet, dass** die wenigstens eine Ausnehmung von einem Randbereich (5) umgeben ist, der rund ausgebildet ist.

11. Elektroaktiver Elastomerwandler nach einem der Ansprüche 1 bis 10,
**dadurch gekennzeichnet, dass** wenigstens zwei stapelförmig übereinander angeordnete, elektroaktive Elastomerschichten vorgesehen sind, zwischen denen jeweils ein Elektrodenkörper eingebracht ist, der wenigstens einseitig zur jeweils angrenzenden Elastomerschicht eine Elektrodenoberfläche mit wenigstens einer Ausnehmung vorsieht, in der das kompressible Medium enthalten ist.

12. Elektroaktiver Elastomerwandler nach einem der Ansprüche 1 bis 10,
**dadurch gekennzeichnet, dass** eine beliebige Vielzahl stapelförmig übereinander angeordnete, elektroaktive Elastomerschichten vorgesehen ist, zwischen denen jeweils ein Elektrodenkörper eingebracht ist, von denen wenigstens ein Elektrodenkörper wenigstens einseitig zur jeweils angrenzenden Elastomerschicht eine Elektrodenoberfläche mit wenigstens einer Ausnehmung vorsieht, in der das kompressible Medium enthalten ist.

13. Elektroaktiver Elastomerwandler nach Anspruch 12,
**dadurch gekennzeichnet, dass** die flächig ausgebildeten Elektrodenkörper in zwei Gruppen unterteilbar sind, eine erste Gruppe von Elektrodenkörper mit Ausnehmungen und eine zweite Gruppe von Elektrodenkörper ohne Ausnehmungen, und dass sich die Gruppenzugehörigkeit der Elektrodenkörper in Stapelrichtung abwechselt.

14. Elektroaktiver Elastomerwandler nach Anspruch 12,
**dadurch gekennzeichnet, dass** wenigstens zwei mit Ausnehmungen versehene Elektrodenkörper vorgesehen sind, deren Ausnehmungen in Stapelrichtung vollständig, teilweise oder nicht überlappen.

15. Elektroaktiver Elastomerwandler nach einem der Ansprüche 1 bis 14,
**dadurch gekennzeichnet, dass** das kompressibles Medium Luft ist.

16. Verwendung eines elektroaktiven Elastomerwandlers nach einem der Ansprüche 1 bis 15 als adaptiver Tilger, **dadurch gekennzeichnet, dass** zwischen wenigstens zwei, wenigstens eine Elastomerschicht (3) beidseitig begrenzenden Elektrodenkörpern (1') eine elektrische Spannung anlegbar ist, durch die ein dem Elastomerwandler zuordenbares resonantes Schwingungsverhalten veränderbar ist.

17. Verwendung eines elektroaktiven Elastomerwandlers nach einem der Ansprüche 1 bis 15 als Flächenlautsprecher oder als aktiv regelbare Wandimpedanz,
**dadurch gekennzeichnet, dass** zwischen wenigstens zwei, wenigstens eine Elastomerschicht (3) beidseitig begrenzenden Elektrodenkörpern (1') eine elektrische Steuerspannung anlegbar ist, durch die ein dem Elastomerwandler zuordenbares Schwingungsverhalten einprägbar ist.

18. Verwendung nach Anspruch 16 oder 17,
**dadurch gekennzeichnet, dass** längs einer Ober- und/oder Unterseite einer Elastomerschicht wenigstens zwei Elektrodenkörper räumlich getrennt voneinander angebracht sind, an die eine einheitliche oder individuelle elektrische Spannung bzw. Steuerspannung anlegbar sind.

## Claims

1. An electroactive elastomer converter with at least one electroactive elastomer layer (3) comprising a topside and an underside as well as with an electrically conducting electrode body (1') which is connected with the topside and, at least in sections, is areally connected with the underside, wherein at least one electrode body (1') comprises an electrode surface facing the elastomer layer (3), in which at least one recess (2) exists which is assignable to a surface region in which there is no areal bond between the elastomer layer (3) and the electrode body (1'),
**characterised in that** the at least one recess (2) is limited on one side by the elastomer layer (3) and a compressible medium is provided in the region of the recess (2).

2. The electroactive elastomer converter according to claim 1,
**characterised in that** the electrode body (1') is rigid to stretching.

3. The electroactive elastomer converter according to claim 1 or 2,
**characterised in that** the electrode body (1') comprises an E-module which is larger by at least four orders of magnitude than an E-module assignable to the elastomer layer (3).

4. The electroactive elastomer converter according to one of claims 1 to 3,
**characterised in that** the electrode body (1') is configured as an electrically conducting layer (1), and **in**
**that** at least one recess is configured as a hole (2) or a perforation which completely penetrates through the electrically conducting layer (1).

5. The electroactive elastomer converter according to one of claims 1 to 3,
**characterised in that** the at least one recess in the electrode surface of the electrode body facing the elastomer layer (3) has a concave shape (4), i.e. it is designed as a kind of depression formed in the electrode surface.

6. The electroactive elastomer converter according to one of claims 1 to 5,
**characterised in that** the electrode body (1') is configured as the metal sheet or a metal foil.

7. The electroactive elastomer converter according to claim 4,
**characterised in that** the at least one hole (2) or the at least one perforation comprises a diameter which corresponds to a layer thickness assignable to the elastomer layer (3) or the electrode body (1').

8. The electroactive elastomer converter according to claim 5,
**characterised in that** the at least one depression (4) comprises a maximum diameter dimension which corresponds to a layer thickness assignable to the elastomer layer (3) or the electrode body (1').

9. The electroactive elastomer converter according to claim 5 or 8,
**characterised in that** the at least one depression together with the elastomer layer encloses a volume in a gas-tight manner, in which the compressible medium is enclosed.

10. The electroactive elastomer converter according to one of claims 1 to 9,
**characterised in that** the at least one recess is surrounded by an edge region (5) which is configured to be round.

11. The electroactive elastomer converter according to one of claims 1 to 10,
**characterised in that** provision is made for at least two electroactive elastomer layers arranged on top of each other in the form of a stack which respectively have an electrode body inserted between them, which, at least on one side of the respectively adjacent elastomer layer, provides an electrode surface with at least one recess which the compressible medium is contained.

12. The electroactive elastomer converter according to one of claims 1 to 10,
**characterised in that** a random plurality of electroactive elastomer layers arranged in a stack on top of each other is provided, which have an electrode body inserted between each of them, of which at least one electrode body provides, at least on one side of the respectively adjacent elastomer layer, an electrode surface with at least one recess, in which the compressible medium is contained.

13. The electroactive elastomer converter according to claim 12,
**characterised in that** the areally shaped electrode bodies can be divided into two groups, a first group of electrode bodies with recesses and a second group of electrode bodies without recesses and **in that** the group association of the electrode bodies alternates in stacking direction.

14. The electroactive elastomer converter according to claim 12,
**characterised in that** at least two electrode bodies with recesses are provided where the recesses completely or partially overlap or do not overlap in stacking direction.

15. The electroactive elastomer converter according to one of claims 1 to 14,
**characterised in that** the compressible medium is air.

16. A use of an electroactive elastomer converter according to one of claims 1 to 15 as an adaptive mass damper,
**characterised in that** an electric voltage can be applied between at least two electrode bodies (1') limiting at least one elastomer layer (3) on both sides, by means which a resonant vibration behaviour assignable to the elastomer converter can be varied.

17. The use of an electroactive elastomer converter according to one of claims 1 to 15 as a flat-panel loudspeaker or as an actively controllable wall impedance,
**characterised in that** an electric control voltage can be applied between at least two electrode bodies (1') limiting at least one elastomer layer (3) on both sides, by means of which a vibration behaviour assignable to the elastomer converter can be imprinted.

18. The use according to claim 16 or 17,
**characterised in that** at least two spatially separated electrode bodies are attached along a topside and/or an underside of an elastomer layer and **in that** a uniform or individual electric voltage or control voltage can be applied to them.

## Revendications

1. Convertisseur élastomère électroactif avec au moins une couche élastomère (3) électroactive, laquelle présente une face supérieure et une face inférieure, ainsi qu'un corps d'électrode (1') électroconducteur relié en nappe au moins par endroits à la face supérieure et à la face inférieure, dans lequel au moins un corps d'électrode (1') possède respectivement une surface d'électrode tournée vers la couche élastomère (3) dans laquelle surface au moins un évidement (2) est présent auquel on peut associer une zone surfacique dans laquelle il n'y a pas de liaison surfacique entre la couche élastomère (3) et le corps d'électrode (1'),
**caractérisé en ce que** l'au moins un évidement (2) est délimité d'un côté par la couche élastomère (3) et **en ce qu'**un milieu compressible est prévu dans la zone de l'évidement (2).

2. Convertisseur élastomère électroactif selon la revendication 1,
**caractérisé en ce que** le corps d'électrode (1') résiste à l'allongement.

3. Convertisseur élastomère électroactif selon la revendication 1 ou 2,
**caractérisé en ce que** le corps d'électrode (1') possède un module E, lequel est plus grand au moins de l'ordre de quatre ordres de grandeur qu'un module E pouvant être associé à la couche élastomère (3).

4. Convertisseur élastomère électroactif selon l'une des revendications 1 à 3,
**caractérisé en ce que** le corps d'électrode (1') est réalisé en tant qu'une couche électro-conductrice (1), et
**en ce que** l'au moins un évidement est réalisé sous la forme d'un trou (2) ou d'une perforation qui traverse complètement la couche électro-conductrice (1).

5. Convertisseur élastomère électroactif selon l'une des revendications 1 à 3,
**caractérisé en ce que** l'au moins un évidement dans la surface d'électrode tournée vers la couche élastomère (3) du corps d'électrode possède une forme concave (4), c'est-à-dire de type cuvette aménagée dans la surface d'électrode.

6. Convertisseur élastomère électroactif selon l'une des revendications 1 à 5,
**caractérisé en ce que** le corps d'électrode (1') est réalisé en tant que tôle métallique ou feuille métallique.

7. Convertisseur élastomère électroactif selon la revendication 4,
**caractérisé en ce que** l'au moins un trou (2) ou l'au moins une perforation possède un diamètre, lequel correspond à une épaisseur de couche pouvant être associée à la couche élastomère (3) ou au corps d'électrode (1').

8. Convertisseur élastomère électroactif selon la revendication 5,
**caractérisé en ce que** l'au moins une cuvette (4) possède une dimension de diamètre la plus grande, laquelle correspond à une épaisseur de couche pouvant être associée à la couche élastomère (3) ou au corps d'électrode (1').

9. Convertisseur élastomère électroactif selon la revendication 5 ou 8,
**caractérisé en ce que** l'au moins une cuvette renferme un volume de manière étanche aux gaz avec la couche élastomère, dans lequel volume le milieu compressible est enfermé.

10. Convertisseur élastomère électroactif selon l'une des revendications 1 à 9,
**caractérisé en ce que** l'au moins un évidement est entouré par une zone de bord (5), laquelle est réalisée de manière ronde.

11. Convertisseur élastomère électroactif selon l'une des revendications 1 à 10,
**caractérisé en ce que** l'on prévoit au moins deux couches élastomères électroactives disposées l'une au-dessus de l'autre en forme de pile, entre lesquelles respectivement un corps d'électrode est inséré, lequel prévoit, au moins d'un côté vers la couche élastomère respectivement adjacente, une surface d'électrode avec au moins un évidement, lequel contient le milieu compressible.

12. Convertisseur élastomère électroactif selon l'une des revendications 1 à 10,
**caractérisé en ce que** l'on prévoit une quantité au choix de couches élastomères électroactives disposées les unes au-dessus des autres en forme de pile, entre lesquelles respectivement un corps d'électrode est inséré, au moins un corps d'électrodes parmi ceux-ci prévoyant, au moins d'un côté vers la couche élastomère respectivement adjacente, une surface d'électrode avec au moins un évidement, lequel contient le milieu compressible.

13. Convertisseur élastomère électroactif selon la revendication 12,
**caractérisé en ce que** les corps d'électrode réalisés en nappe peuvent être partagés en deux groupes, un premier groupe de corps d'électrodes avec des évidements et un second groupe de corps d'électrodes sans évidements, et **en ce que** l'appartenance à un groupe des corps d'électrode alterne dans le sens de l'empilement.

14. Convertisseur élastomère électroactif selon la revendication 12,
**caractérisé en ce que** l'on prévoit au moins deux corps d'électrode munis d'évidements, dont les évidements se superposent complètement, partiellement, ou ne se superposent pas, dans le sens de l'empilement.

15. Convertisseur élastomère électroactif selon l'une des revendications 1 à 14,
**caractérisé en ce que** le milieu compressible est de l'air.

16. Utilisation d'un convertisseur élastomère électroactif selon l'une des revendications 1 à 15 en tant qu'amortisseur adaptif,
**caractérisée en ce que**, entre au moins deux corps d'électrodes (1') délimitant au moins une couche élastomère (3) des deux côtés, une tension électrique peut être appliquée grâce à laquelle il est possible de faire varier un comportement vibratoire résonant pouvant être associé au convertisseur élastomère.

17. Utilisation d'un convertisseur élastomère électroactif selon l'une des revendications 1 à 15 en tant que haut-parleur plan ou en tant qu'impédance de paroi réglable activement,
**caractérisée en ce que**, entre au moins deux corps d'électrodes (1') délimitant au moins une couche élastomère (3) des deux côtés, une tension de commande électrique peut être appliquée grâce à laquelle il est possible d'imprimer un comportement vibratoire pouvant être associé au convertisseur élastomère.

18. Utilisation selon la revendication 16 ou 17,
**caractérisée en ce que**, le long d'une face supérieure et/ou inférieure d'une couche élastomère, au moins deux corps d'électrode sont placés de manière séparée l'un de l'autre dans l'espace, auxquels il est possible d'appliquer une tension électrique ou une tension de commande individuelle ou uniforme.
